# EUROPEAN PATENT SPECIFICATION

(11) **EP 0 727 872 B1**
(45) Date of publication and mention of the grant of the patent: **29.11.2000**
(21) Application number: 96101993.2
(22) Date of filing: 12.02.1996
(51) Int. Cl.: H03H 9/05

(54) **Piezoelectric oscillator, voltage-controlled oscillator, and production method thereof**
Piezoelektrischer Oszillator, spannungsgesteuerter Ozillator, und Herstellungsverfahren derselben
Oscillateur piézo-électrique, oscillateur commandé en tension et méthode de leur production

(30) Priority: 15.02.1995 JP 2717095; 03.10.1995 JP 25662395; 10.01.1996 JP 269396
(43) Date of publication of application: 21.08.1996
(73) Proprietor: SEIKO EPSON CORPORATION, Shinjuku-ku, Tokyo 163-0811 (JP)
(72) Inventor: Oka, Manabu, c/o Seiko Epson Corporation, Suwa-shi, Nagano-ken, 392 (JP); Nakajima, Yukari, c/o Seiko Epson Corporation, Suwa-shi, Nagano-ken, 392 (JP); Kikushima, Masayuki, c/o Seiko Epson Corporation, Suwa-shi, Nagano-ken, 392 (JP); Shimodaira, Kazuhiko, c/o Seiko Epson Corporation, Suwa-shi, Nagano-ken, 392 (JP)
(74) Representative: Hoffmann, Eckart, Dipl.-Ing.

(56) References cited:
- PATENT ABSTRACTS OF JAPAN vol. 013, no. 031 (E-707), 24 January 1989 & JP-A-63 232603 (NEC CORP), 28 September 1988,
- PATENT ABSTRACTS OF JAPAN vol. 017, no. 044 (E-1312), 27 January 1993 & JP-A-04 259104 (SEIKO EPSON CORP), 14 September 1992,
- PATENT ABSTRACTS OF JAPAN vol. 010, no. 168 (E-411), 14 June 1986 & JP-A-61 019204 (MATSUSHIMA KOGYO KK), 28 January 1986,
- PATENT ABSTRACTS OF JAPAN vol. 017, no. 702 (E-1482), 21 December 1993 & JP-A-05 243471 (SEIKO EPSON CORP), 21 September 1993,
- PATENT ABSTRACTS OF JAPAN vol. 95, no. 004 & JP-A-07 099413 (CITIZEN WATCH CO LTD), 11 April 1995,

## Description

The present invention relates to a piezoelectric oscillator including a semiconductor integrated circuit and a piezoelectric resonator, relates to a voltage-controlled oscillator including a semiconductor integrated circuit, a piezoelectric resonator, and another electronic component, and relates to a production method thereof.

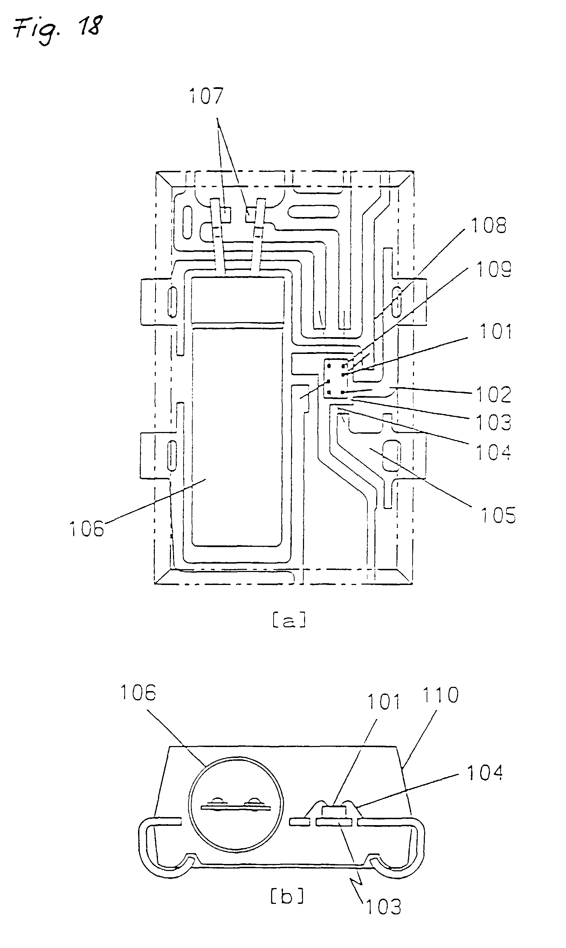

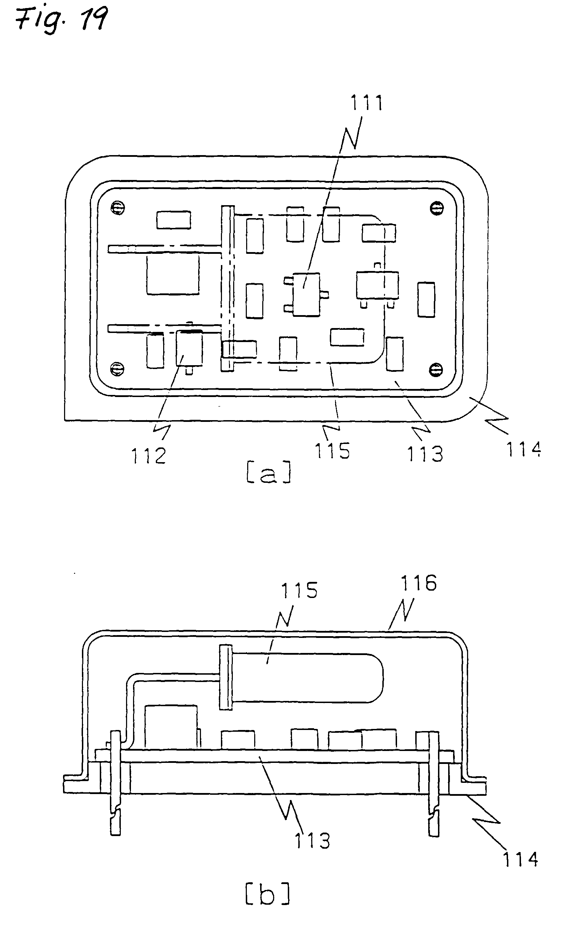

In recent years, great reductions in size and weight have been achieved in various information equipment such as an HDD (hard disk drive) or portable computer and mobile communication systems such as a portable telephone or mobile telephone. As a result, it is required to reduce the size, particularly thickness, of piezoelectric oscillators and voltage-controlled oscillators for use in these devices. Thus, there is a need for piezoelectric oscillators and voltage-controlled oscillators of the surface mounting type that can be mounted on the surface of a circuit board of a device. Figures 18a and 18b illustrate an example of a conventional piezoelectric oscillator employing a quartz-crystal resonator as a piezoelectric resonator, and Figures 19a and 19b illustrate an example of a conventional voltage-controlled (crystal) oscillator (VCXO).

In the conventional quartz-crystal oscillator shown in Figures 18a and 18b, an IC chip 101 for example of the CMOS type is mounted via for example a conductive adhesive on an island 103 which is a part of a lead frame 102. The IC chip 101 is electrically connected to input/output lead terminals 105 via (wire-bonded) gold (Au) wires 104. A quartz-crystal resonator 106 is fixed to inner lead electrodes 107 wherein the quartz-crystal resonator 106 includes a quartz chip in the form of a cylinder having a circular cross-section with a diameter of about 3 mm. The quartz-crystal resonator 106 is electrically connected to the gate electrode 108 and the drain electrode 109 of the IC chip 101. The IC chip 101, the quartz-crystal resonator 106, and parts of input/output lead terminals 105 are molded by means of for example transfer molding with an epoxy resin thereby forming a plastic package 110 of the quartz-crystal oscillator.

In the conventional voltage-controlled oscillator, as shown in Figures 19a and 19b, electric circuit components such as a transistor 111, variable-capacitance diode 112, etc., are mounted on a substrate 113 which is fixed via solder or the like on the stem 114 of a metal can package wherein a quartz-crystal resonator 115 is also mounted on the substrate 113. The can 116 is hermetically sealed by means of for example resistance welding. This discrete type is widely used in the art. In another common type, a trimmer capacitor or the like is also provided on the substrate 113, and an adjusting hole is formed in the can 116 so that the frequency may be adjusted after the voltage-controlled oscillator is mounted on a circuit board installed in a device such as a mobile communication system.

In the conventional piezoelectric oscillator and voltage-controlled oscillator described above, a piezoelectric resonator comprises a case having a diameter or thickness of about 3 mm. As a result, the piezoelectric oscillator or voltage-controlled oscillator has a great height such as about 4.5 mm to 7 mm and thus its total volume is as great as 0.5 cc to 1.0 cc. Therefore, the conventional piezoelectric oscillator and voltage-controlled oscillator of this type cannot meet the small-size requirement which is essential in small-sized electronic devices such as a HDD, a portable computer, a portable or mobile telephone, etc.

To reduce the thickness of a piezoelectric oscillator or voltage-controlled oscillator, it is required to reduce the thickness of the piezoelectric resonator disposed therein. There are two known techniques for this purpose.

A first technique is to employ a piezoelectric element having a smaller size and dispose it in a case having a smaller diameter or thickness. If the diameter of the piezoelectric resonator is reduced to for example 1.5 mm, the size of the piezoelectric element will have to be 0.5 to 0.7 mm (W) by 5.6 mm (L) which is much smaller than a typical size of 1.8 to 2.0 mm (W) by 5.6 mm (L) of a piezoelectric element disposed in a case having a diameter or thickness of 3 mm. However, there is difficulty in designing and producing a piezoelectric element such as a quartz chip having such a small size while maintaining the required performance. This technique is thus expensive and not practical.

The second technique is to reduce the thickness by forming the cross-section of the piezoelectric resonator into an elliptical shape or a track shape (the term "track shape" and "track-like shape" are used herein to refer to a shape that is substantially formed by the combination of a rectangle and two semicircles). In this technique, the piezoelectric element disposed in the case is allowed to have a size similar to that of the conventional piezoelectric element. Therefore it is possible to produce a piezoelectric element without increasing the cost.

An example of a piezoelectric oscillator produced using the second technique described above is disclosed in JP-A-4-259104 (1992). In this example, the small-sized oscillator employs a piezoelectric resonator whose cross-section at one end is flat.

When a piezoelectric oscillator or voltage-controlled oscillator is molded with a resin, an injection pressure is imposed uniformly on a piezoelectric resonator and a semiconductor integrated circuit disposed in the oscillator. In particular, in the piezoelectric resonator, a hollow case is employed, and a piezoelectric element is disposed therein. Therefore, it is required that the case should have mechanical strength strong enough not to be deformed by the pressure during the molding process so that the piezoelectric element does not come in contact with the inner wall of the case and no strain occurs either in the piezoelectric element or in the mounting part.

The deformation of the case also depends on the shape of the piezoelectric resonator. A computer simulation using structure analysis software has revealed that in the case of a piezoelectric resonator having an elliptic or track-like cross-section, non-uniform deformation is induced by a uniform pressure arising during a molding process wherein greater deformation occurs in parts of the case parallel to the major axis of the ellipse or in linear parts of the track shape, as opposed to the cylinder type in which deformation occurs uniformly. Similar empirical results have been observed in experiments on the effects of molding on the deformation.

The deformation of the case caused by the shrinkage of the molding resin also depends on the location at which the piezoelectric resonator is disposed in the piezoelectric oscillator or voltage-controlled oscillator. That is, when the molding resin shrinks and thermal stress occurs in the molding resin, the thermal stress varies from part to part of the package of the piezoelectric oscillator or voltage-controlled oscillator. Therefore it is also required to optimize the location of the piezoelectric resonator and the structure of the piezoelectric oscillator or voltage-controlled oscillator.

In the example shown in JP-A-4-259104 (1992), an IC chip is attached to a flat part in cross-section of a piezoelectric resonator. The piezoelectric resonator and the IC chip are then disposed in the substantially central part of a piezoelectric oscillator, and these are molded with a resin.

However, to attach an IC on the flat part of the piezoelectric resonator, the area of the flat part needs to be greater than the area of the IC. Therefore, it is required to increase the area of the flat part so that it exceeds the size of the IC chip. To increase the area of the flat part of the piezoelectric resonator, it is required to increase the length of the linear part of the track shape. This results in an increase in the pressure applied to the piezoelectric resonator during a molding process, which in turn results in an increase in the deformation of the case.

Since the thickness of the resin disposed on the piezoelectric resonator is greater on the side near the IC chip than on the opposite side, the part of the resonator near the IC chip has greater deformation than the opposite part.

As described above, to achieve a reduction in the thickness of a piezoelectric oscillator or voltage-controlled oscillator employing a piezoelectric resonator having an elliptic or track-like cross-section, it is required to optimize the structure such as the shape of the cross-section of the piezoelectric resonator and the position at which the piezoelectric resonator is disposed.

Furthermore, there is a need for higher accuracy in the oscillation frequency of the piezoelectric oscillator as well as the voltage-controlled oscillator.

It is an object of the present invention to solve the above problems. More specifically, it is an object of the present invention to provide a high-accuracy piezoelectric oscillator and voltage-controlled oscillator having a small size, in particular in thickness, at a low cost.

This object is achieved by the present invention as set forth in claims 1, 10, 13 and 23. Advantageous embodiments are set forth in the dependent claims.
- Fig. 1: is a schematic diagram of an embodiment of a piezoelectric oscillator according to the present invention, wherein Fig. 1a illustrates its plan view and Fig. 1b illustrates its cross-sectional view;
- Fig. 2: is a block diagram of a piezoelectric oscillator according to the present invention;
- Fig. 3: is a schematic diagram of a piezoelectric resonator used in a piezoelectric oscillator and a voltage-controlled oscillator according to the present invention, wherein Fig. 3a is a cross-sectional view taken along line A-A of Fig. 3b, and Fig. 3b is a side view thereof;
- Fig. 4: is a schematic diagram showing the piezoelectric oscillator of Fig. 1 placed in a transfer mold, wherein Fig. 4a is a plan view, Fig. 4b is a side view, and Fig. 4c is a cross-sectional view taken along line A-A of Fig. 4a;
- Fig. 5: is a schematic diagram illustrating a piezoelectric oscillator subjected to a frequency adjustment step, according to the present invention;
- Fig. 6: is a perspective view of a piezoelectric oscillator according to the present invention;
- Fig. 7: is a circuit diagram of another embodiment of a piezoelectric oscillator according to the present invention;
- Fig. 8: is a schematic diagram illustrating a piezoelectric oscillator subjected to a frequency adjustment step, according to the present invention;
- Fig. 9: is a graph illustrating an ideal characteristic curve used to adjust the frequency of the piezoelectric oscillator according to the present invention;
- Fig. 10: is a schematic diagram of an embodiment of a voltage-controlled oscillator according to the present invention, wherein Fig. 10a is a plan view, and Fig. 10b is a cross-sectional view;
- Fig. 11: is a circuit diagram illustrating a circuit configuration of a voltage-controlled oscillator according to the present invention;
- Fig. 12: is a block diagram of a voltage-controlled oscillator according to the present invention;
- Fig. 13: is a schematic diagram of another embodiment of a voltage-controlled oscillator according to the present invention;
- Fig. 14: is a schematic diagram of still another embodiment of a piezoelectric oscillator and voltage-controlled oscillator according to the present invention;
- Fig. 15: is a schematic diagram illustrating a specific example of the cross section of a piezoelectric resonator used in the piezoelectric oscillator and the voltage-controlled oscillator, according to the present invention, wherein Fig. 15a illustrates an elliptic structure, and Fig. 15b illustrates a track-like structure;
- Fig. 16: is a schematic representation of the result of computer analysis on deformation using structural analysis software, wherein Fig. 16a illustrates the result for a conventional structure, and Fig. 16b illustrates the result for the structure according to the present invention;
- Fig. 17: is a graph illustrating the deformation (strain) of a case of a piezoelectric resonator caused by the injection pressure during a molding process;
- Fig. 18: is a schematic diagram of a conventional piezoelectric oscillator, wherein Fig. 18a is a plan view, and Fig. 18b is a cross-sectional view; and
- Fig. 19: is a schematic diagram of a conventional voltage-controlled oscillator, wherein Fig. 19a is a plan view, and Fig. 19b is a cross-sectional view.

The present invention of a piezoelectric oscillator and a voltage-controlled oscillator will be described in further detail below with reference to preferred embodiments thereof in connection with the accompanying drawings. A quartz-crystal oscillator and a voltage-controlled oscillator including a quartz-crystal resonator serving as the piezoelectric resonator accommodated in a plastic package of the SOJ (small outline J-lead) type are taken here as examples, wherein these are for the purposes of illustration and description, and it is to be appreciated that the invention is not limited to these. The greater part of the voltage-controlled oscillator is the same as the quartz-crystal oscillator, and therefore, the common part will be described only in the quartz-crystal oscillator and no duplicated description will be given in the voltage-controlled oscillator.

### Structure of the quartz-crystal oscillator and production method thereof

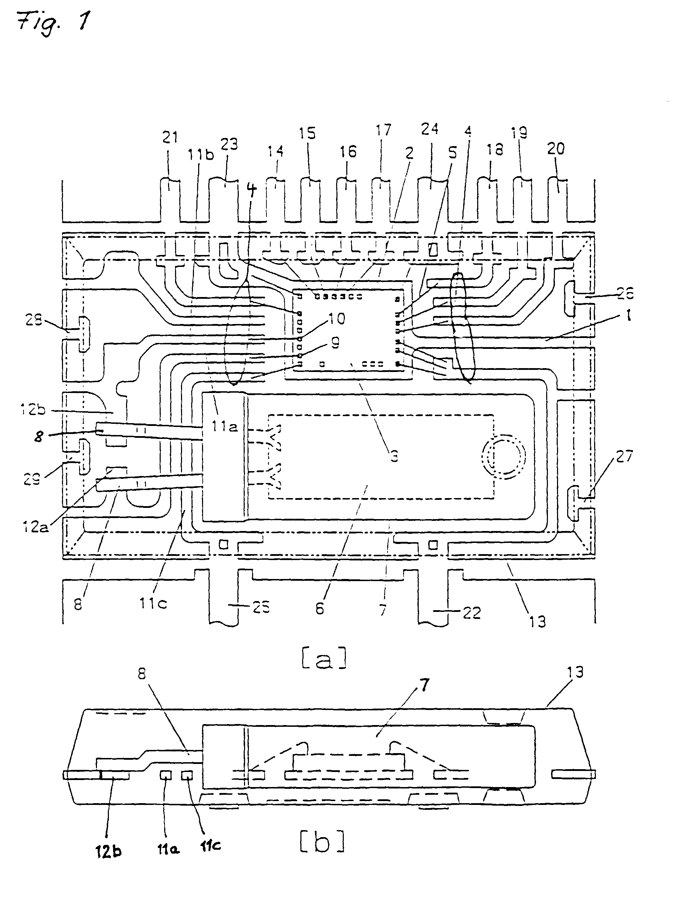

As shown in the plan view of Figure 1a and in the cross-sectional view of Figure 1b, a CMOS semiconductor integrated circuit (hereafter referred to simply as an IC chip) 3 including an oscillating circuit is die-bonded via a conductive adhesive or the like onto an island 2 of a lead frame 1 made up of a high-conductivity metal material such as 42-Alloy having a composition of 42% Ni and 58% Fe or Cu-based alloy. Pads of the IC chip 3 are electrically connected via wire-bonded gold wires 5 to inner lead electrodes 4 disposed around the island 2. The leads 8 of the quartz-crystal resonator 7 containing an AT-cut quartz-crystal chip 6 in the form of a rectangle are mechanically and electrically connected to mounting areas 12a and 12b of the inner lead electrodes 11a and 11b by means of resistance spot welding or laser beam welding.

The XG terminal 9 (on the gate side) and the XR terminal 10 (on the drain side) of the IC chip 3 are electrically connected to the inner lead electrodes 11a and 11b via wire-bonded gold wires 5 so that the quartz-crystal resonator 7 is driven by the IC chip 3 and thus oscillation occurs.

As shown in Figure 1b, the leads 8 are bent so that they cross over inner lead electrodes 11a and 11c and are connected to the mounting areas 12a and 12b. Furthermore, the leads 8 have a length long enough to have an overhang over the mounting areas 12a and 12b. Thus, the quartz-crystal resonator 7 is disposed on the lead frame 1 so that the quartz-crystal resonator 7 is adjacent to the IC chip 3.

Furthermore, the quartz-crystal resonator 7 is located so that the thickness of the resin on the upper side is equal to that on the lower side. In this particular example, the thickness of the resin is set to about 0.2 mm for either side. On a longer side of the quartz-crystal oscillator 13, there are provided signal input lead terminals (DO terminal 14, D1 terminal 15, D2 terminal 16, D3 terminal 17, D4 terminal 18, D5 terminal 19, D6 terminal 20, and control terminal 21) by which signals for controlling the oscillation frequency of the quartz-crystal oscillator 13 are applied. The signal input lead terminals are disposed at the side of the IC chip 3 in the quartz-crystal oscillator 13 opposite to the quartz-crystal resonator 7 so that they are aligned perpendicular to the major dimension of the quartz-crystal resonator 7.

Furthermore, a VSS terminal 22, VDD terminal 23, OUT terminal 24, and NC/OE (No-Contact/Output-Enable) terminal 25 are also disposed on the quartz-crystal oscillator 13.

The lead frame is also provided with supporting lead terminals 26, 27, 28, and 29 for supporting the quartz-crystal oscillator 13 during a process of adjusting the oscillation frequency.

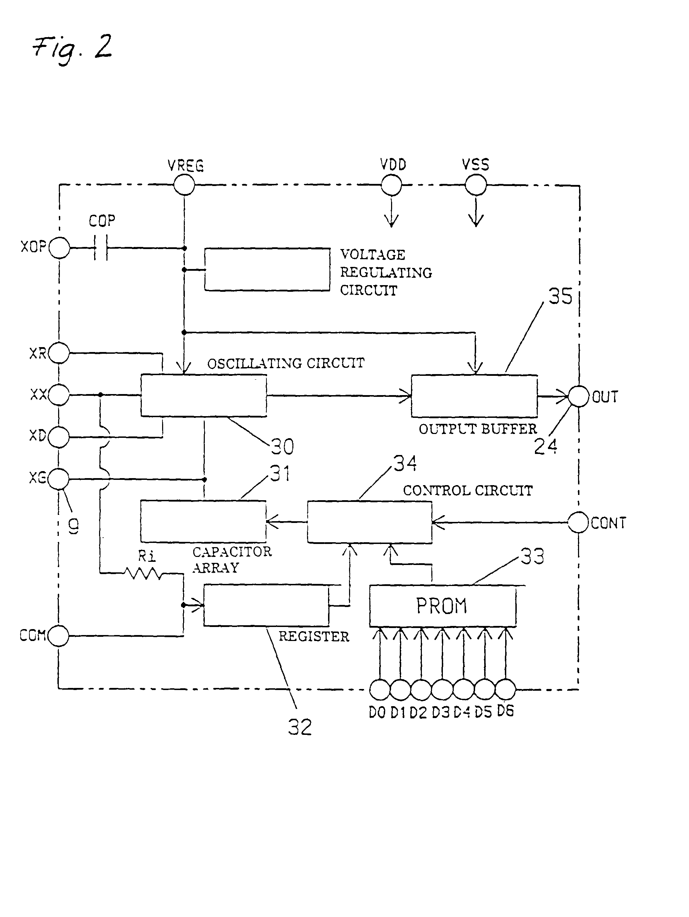

As shown in the block diagram of Figure 2, the IC chip 3 is a one-chip semiconductor device which includes an oscillating circuit 30, capacitor array 31, register 32, PROM 33, control circuit 34, output buffer 35, etc., and which is programmed to change the capacitance associated with the XG terminal 9 by controlling the capacitor array 31 according to the frequency adjustment data and frequency dividing condition data provided by an external source thereby controlling the frequency of the oscillation based on the quartz oscillation wherein the oscillation signal is output via the OUT terminal 24.

The oscillating circuit 30 includes a feedback resistor, CMOS inverter, gate and drain capacitance wherein the capacitor array 31 including seven capacitors for controlling the frequency is coupled to the gate capacitance. The register 32 stores frequency adjustment data which is provided by an external source and used to control the oscillation frequency according to the given program. The proper value of the frequency adjustment data needed to obtain a correct oscillation frequency is established according to a frequency adjustment process described below and is written in the PROM 33 and stored therein. The control circuit 34 controls the capacitor array 31 according to the frequency adjustment data stored in the PROM 33 or register 32. The output buffer 35 amplifies the oscillation signal generated by the oscillating circuit 30.

As shown in Figure 1a, pads for use in this quartz-crystal oscillator 13 are formed in peripheral areas only on three sides of the IC chip 3 and no pads are formed on the side facing the quartz-crystal resonator 7. These pads are electrically connected to the respective inner lead electrodes 4 via wire-bonded gold wires 5.

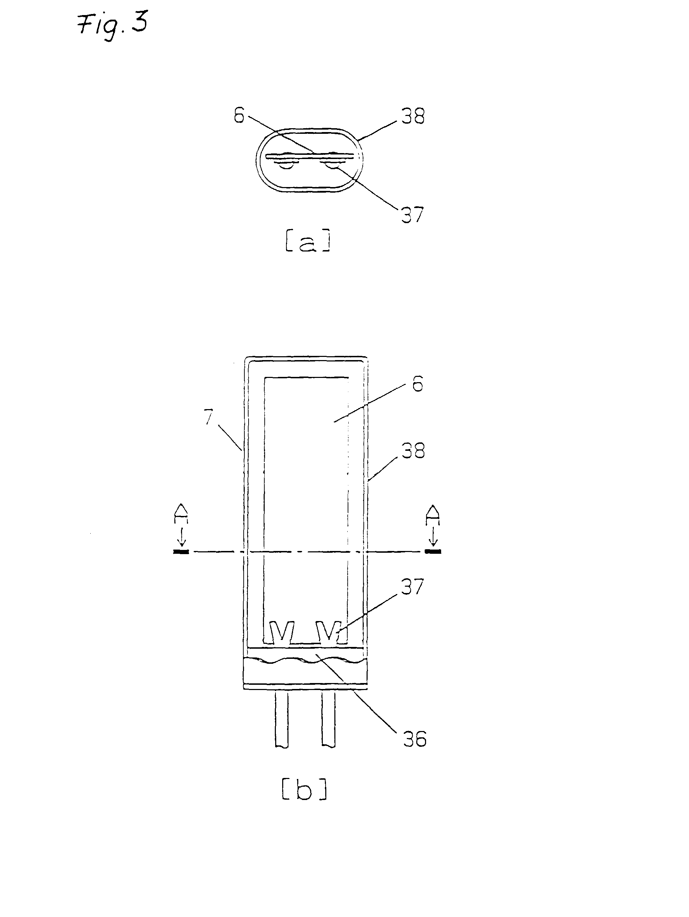

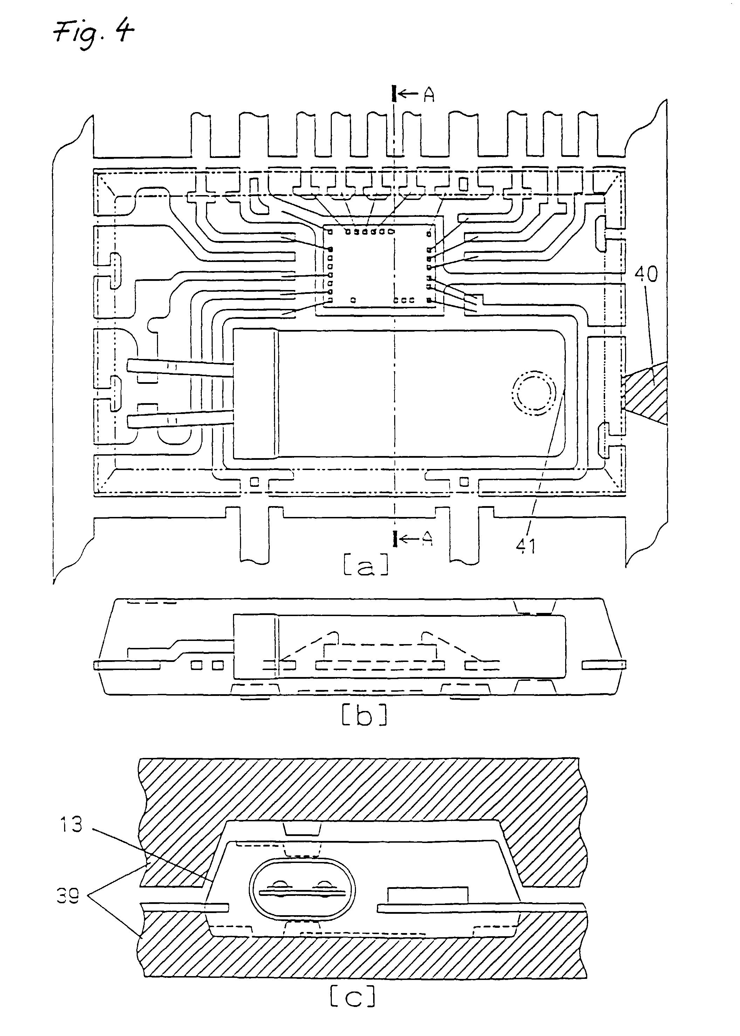

As shown in Figure 3a and 3b (Figure 3a illustrates a cross-section taken along line A-A of Figure 3b), the quartz-crystal resonator 7 of the invention is formed so that its cross-section has a track shape. A rectangular AT quartz-crystal chip 6 is mounted on inner leads 37 connected to a hermetic seal 36 and sealed in a case 38. The AT quartz-crystal chip 6 has a similar size to conventional ones. As a result of employing the case 38 and the hermetic seal or plug 36 whose cross-sections have a track-like shape, it becomes possible to accommodate an AT quartz-crystal chip 6 having a similar size to conventional ones in a case as thin as about 1.5 mm. Thus, a quartz-crystal resonator 7 having a very small thickness can be obtained. The cross-section of the quartz-crystal resonator 7 is not limited to the track shape and may also have another shape such as an ellipse.

As shown in the plan view of Figure 4a, the side view of Figure 4b, and the cross-sectional view of Figure 4c (taken along line A-A of Figure 4a), the lead frame 1 constructed in the above-described manner is placed in a transfer mold 39, and transfer-molded with resin except for outer portions of the inner lead electrodes 4 and the signal input lead terminals (DO terminal 14, D1 terminal 15, D2 terminal 16, D3 terminal 17, D4 terminal 18, D5 terminal 19, D6 terminal 20, and control terminal 21) thereby obtaining a quartz-crystal oscillator 13. In this embodiment, a gate 40 by which a molding resin is injected is formed in a shorter side of the quartz-crystal oscillator 13 so that the molding resin collides with the end portion 41 of the case of the quartz-crystal resonator 7 and thus the molding resin is distributed uniformly.

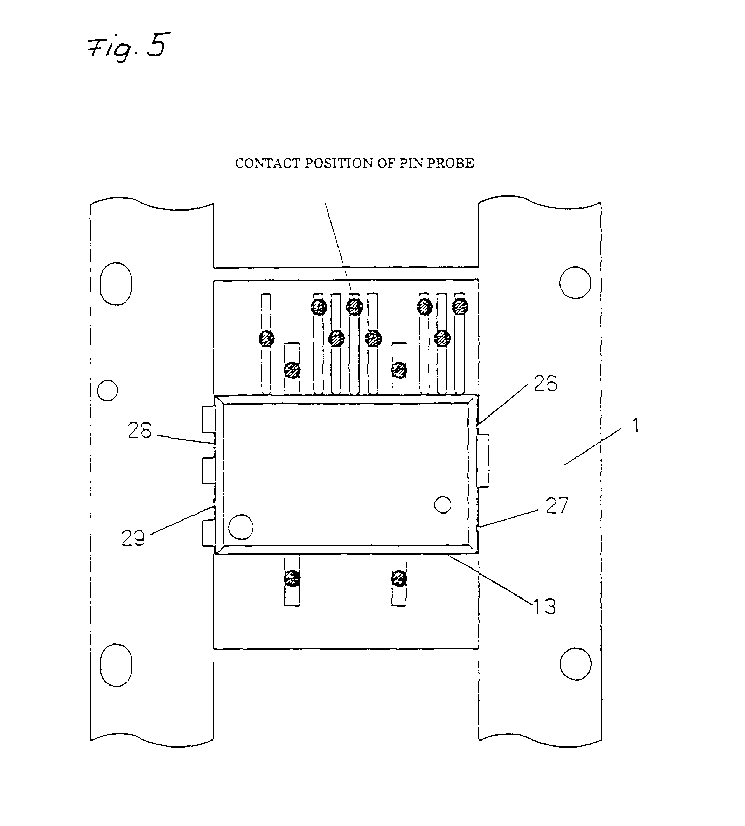

After completion of the resin molding, tie-bars used for connection between input/output electrodes and signal input lead terminals (DO terminal 14, D1 terminal 15, D2 terminal 16, D3 terminal 17, D4 terminal 18, D5 terminal 19, D6 terminal 20, and control terminal 21) are cut off (trimmed). Thus, a plurality of quartz-crystal oscillators 13 (ten quartz-crystal oscillators in one specific embodiment) may be formed on one lead frame 1 where, as shown in Figure 5, each quartz-crystal oscillator 13 is connected to the lead frame 1 via supporting lead terminals 26, 27, 28, and 29. These supporting lead terminals 26, 27, 28, and 29 are formed so that they are isolated from each other and have no connection to any of the input/output leads and signal input lead terminals.

When the frequency is adjusted, pin probes are placed on the leads of each quartz-crystal oscillator at positions indicated by solid circles in Figure 5. Since a plurality of quartz-crystal oscillators 13 are supported by a lead frame 1 in the manner described above, it is possible to adjust the frequency of these quartz-crystal oscillators 13 without having to separate these quartz-crystal oscillators 13 from the lead frame 1. The frequency adjustment may be performed in a one-by-one fashion or for a plurality of quartz-crystal oscillators at the same time. This allows the frequency adjustment process to be incorporated into the production line and thus it is possible to reduce the production cost of the quartz-crystal oscillator.

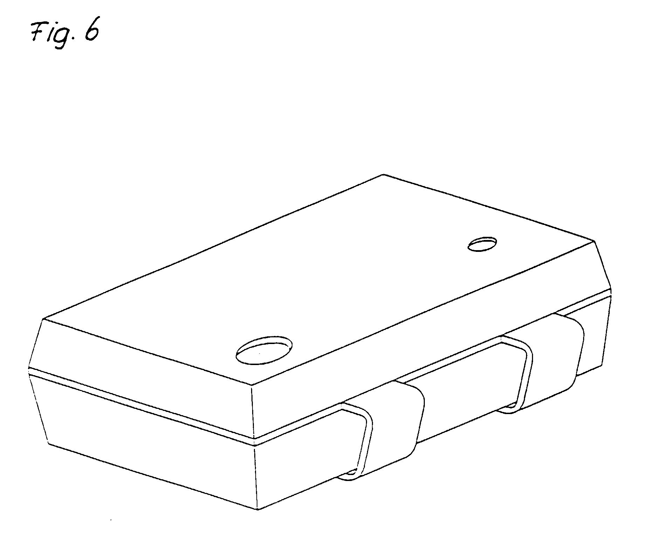

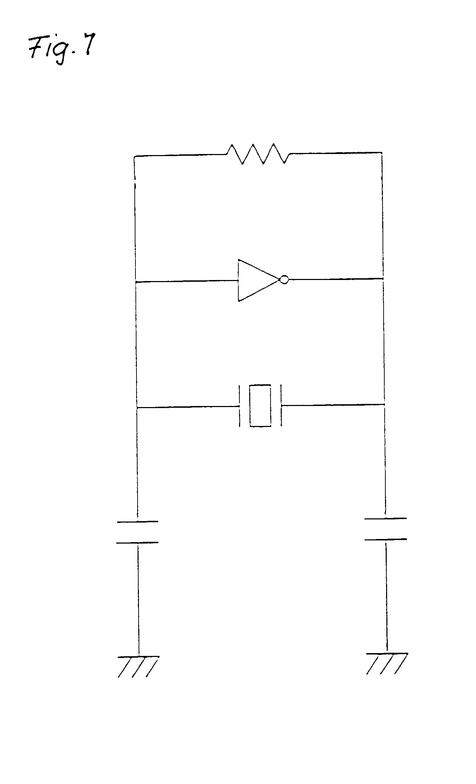

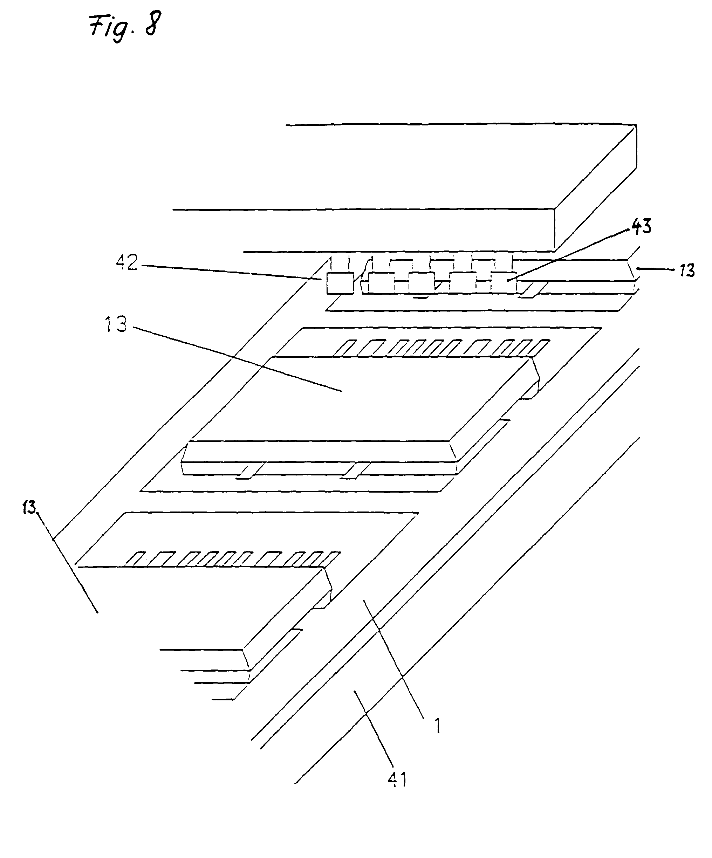

After adjusting the frequency, the quartz-crystal oscillators 13 are cut off from the lead frame 1. In this cutting off process, input/output leads such as VSS terminal 22, VDD terminal 23, OUT terminal 24 and NC/OE terminal 25 are first bent into a J-shape. The signal input lead terminals (D0 terminal 14, D1 terminal 15, D2 terminal 16, D3 terminal 17, D4 terminal 18, D5 terminal 19, D6 terminal 20, and control terminal 21) are then cut off. Finally, the connecting portions between the supporting lead terminals 26, 27, 28, 29 and the lead frame 1 are cut off. Thus, each quartz-crystal oscillator 13 is separated and complete quartz-crystal oscillators of the SOJ type having a structure such as that shown in Figure 6 are obtained.

The quartz-crystal oscillator obtained in the above-described manner has a thickness as small as about 2.0-2.2 mm and a volume of about 0.2 cc.

The cross-section of the quartz-crystal resonator has the special shape as described above. This ensures that the resin is coated uniformly in thickness around the quartz-crystal resonator. As a result, it is possible to improve the filling efficiency of the molding resin. Furthermore, the obtained quartz-crystal oscillator has no cracks in its package and thus shows high reliability.

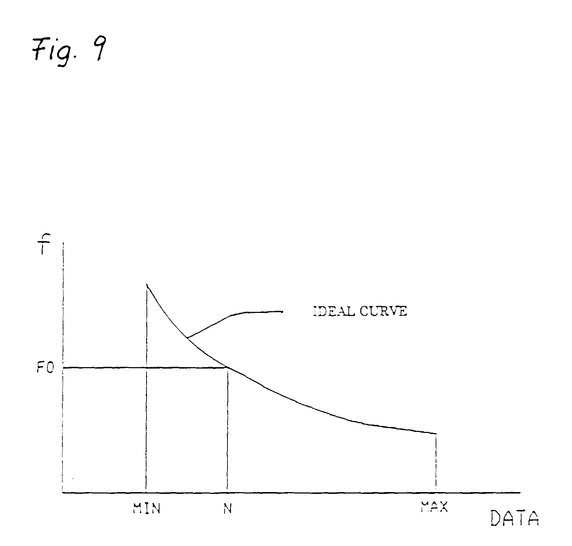

In the embodiment described above, the quartz-crystal oscillator is of the type providing the capability to precisely adjust the oscillation frequency. However, the present invention may also be applied to a simple quartz-crystal oscillator such as that shown in Figure 7 including only an oscillating circuit using a general CMOS circuit.

### Method of adjusting the frequency

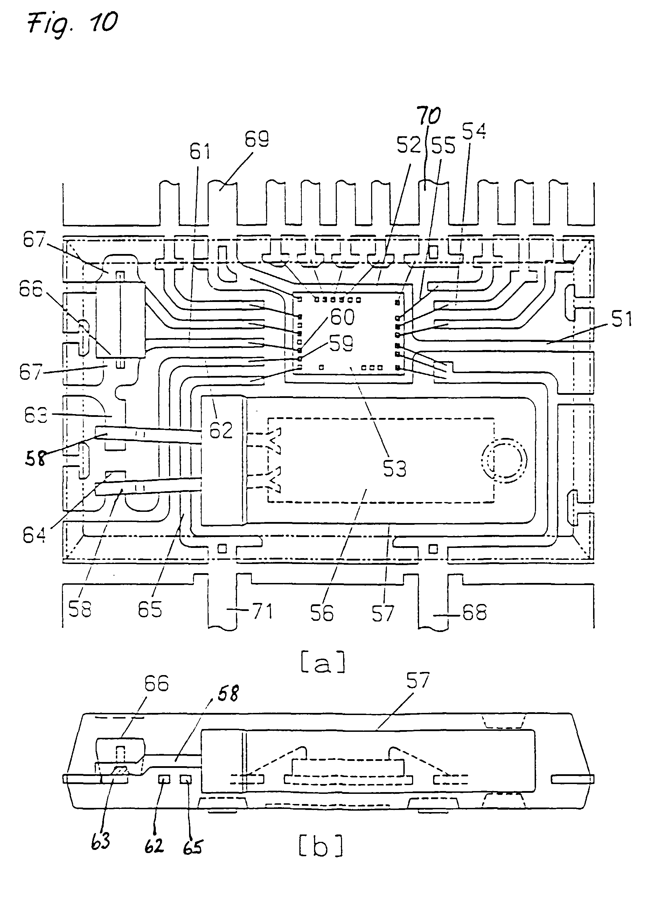

The oscillation frequency of the quartz-crystal oscillator shown in Figure 5 can be adjusted. As shown in Figure 8, a plurality of quartz-crystal oscillators 13 connected to a lead frame 1 are placed on a frequency adjusting device 42. Their oscillation frequency is automatically adjusted according to the following steps.

The pin probes 43 of the frequency adjusting device 42 are placed so that these pin probes come in electric contact with the respective leads of the quartz-crystal oscillator 13. Voltages are applied to the VDD terminal 23 and the VSS terminal 22 so that the quartz-crystal resonator 7 starts an oscillating operation. The MIN data indicated by the ideal curve shown in Figure 9 is input into the counter of the frequency adjusting device 42. A high-level signal and a low-level signal are then applied to the control terminal 21 and the NC/OE terminal 25, respectively, of the quartz-crystal oscillator 13. As a result, the capacitor array 31 comes to be controlled via control circuit 34 by the data stored in the register 32 instead of the data stored in the PROM 33. The data N in the counter of the frequency adjusting device 42 causes N pulses to be input into the register 32 via the NC/OE terminal 25 so that data N is stored in the register 32. The frequency (F1) of the oscillating signal output via the OUT terminal 24 is monitored. If the oscillation frequency (F1) is equal to the target frequency (F0), the frequency adjustment has been completed. If the oscillation frequency (F1) is not equal to the target frequency (F0), the data in the counter of the frequency adjusting device 42 is modified and the above-described process is performed repeatedly until the oscillation frequency (F1) converges to the target frequency (F0).

The data in the counter of the frequency adjusting device 42, which has been finally obtained in the frequency adjustment process described above, is then written in the PROM 33 so that the result of the frequency adjustment is stored in the PROM 33. The writing of the data into the PROM 33 is performed by "blowing" or opening fuses in the PROM 33 corresponding to the terminals having a "0" level when the above data in binary form corresponds to the respective terminals from D0 (14) to D6 (20). The opening of the fuses is performed by applying a writing voltage to the terminals connected to the fuses to be opened while maintaining the VDD terminal 23 at the ground level.

Figure 8 shows only one example of a manner in which the frequency is adjusted, and the pin probes 43 may be placed in another direction. Furthermore, the piezoelectric oscillator may be placed on the frequency adjusting device 42 in either an up-side-up manner or an up-side-down manner.

The production flow described above is only one of possible examples and the production may also be performed in different orders.

### The structure of the voltage-controlled oscillator and production method thereof

As shown in the plan view of Figure 10a and in the cross-sectional view of Figure 10b, a CMOS IC chip 53 is die-bonded via a conductive adhesive or the like onto an island 52 of a lead frame 51 made up of a high-conductivity metal material such as 42-Alloy having a composition of 42% Ni and 58% Fe or Cu-based alloy. The pads of the IC chip 53 are electrically connected via wire-bonded gold wires 55 to inner lead electrodes 54 disposed around the island 52. The leads 58 of the quartz-crystal resonator 57 containing an AT quartz-crystal chip 56 in the form of a rectangle are mechanically and electrically connected to mounting areas 63 and 64 of the inner lead electrodes 61 and 62 by means of resistance spot welding or laser beam welding. The XG terminal 59 (on the gate side) and the XR terminal 60 (on the drain side) of the IC chip 53 are electrically connected to the inner lead electrodes 61 and 62 via wire-bonded gold wires 55 so that the quartz-crystal resonator 57 is driven by the IC chip 53 and thus oscillation occurs.

As shown in Figure 10b, the leads 58 of the quartz-crystal resonator 57 are bent so that they cross over inner lead electrodes 62 and 65 and are connected to the mounting areas 63 and 64. Furthermore, the leads 58 have a length long enough to have an overhang over the mounting areas 63 and 64. Thus, the quartz-crystal resonator 57 is disposed on the lead frame 51.

As in the quartz-crystal resonator 7 described above in connection with Figure 3, the cross-section of the quartz-crystal resonator 57 of the present embodiment also has a track shape. The quartz-crystal resonator 57 is constructed by mounting a rectangular AT quartz-crystal chip on inner leads supported by a hermetic seal and placing it in a case and finally sealing the case. The quartz-crystal resonator 57 has a size as thin as about 1.5 mm.

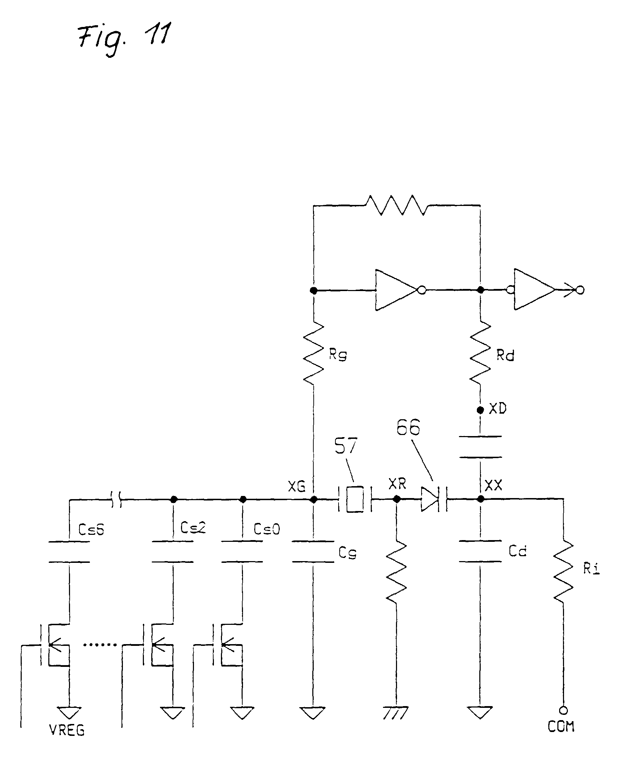

Electronic components such as a variable-capacitance diode 66 shown in the circuit diagram of Figure 11 are attached to the land 67 of the lead frame 51 by means of resistance spot welding, laser beam welding, soldering, or using a conductive adhesive, as shown in Figure 10a.

The connecting positions of the quartz-crystal resonator 57 and the variable-capacitance diode 66 are located on the same straight line. An advantage of this arrangement is that a welding head for making connection of these elements can be moved easily and quickly to a correct position and thus it is possible to easily attach two different components at different positions.

In this embodiment, as shown in Figure 11, the oscillating circuit of the voltage-controlled oscillator includes an inverter, a feedback resistor, and an oscillation capacitor. The quartz-crystal resonator 57 and the variable-capacitance diode 66 are connected in series between the output and input terminals of the inverter wherein a DC-blocking capacitor is disposed between the variable-capacitance diode 66 and the inverter. The node between the piezoelectric resonator 57 and the variable-capacitance diode 66 is connected to ground via a bias resistor. A control voltage or modulation signal is applied to the node between the variable-capacitance diode 66 and the DC-blocking capacitor thereby changing the capacitance of the variable-capacitance diode 66 and thus changing the oscillation frequency. Signal input lead terminals and supporting lead terminals are also provided as in the quartz-crystal oscillator. There are also provided input/output terminals including VSS terminal 68, VDD terminal 69, OUT terminal 70, and VC terminal 71.

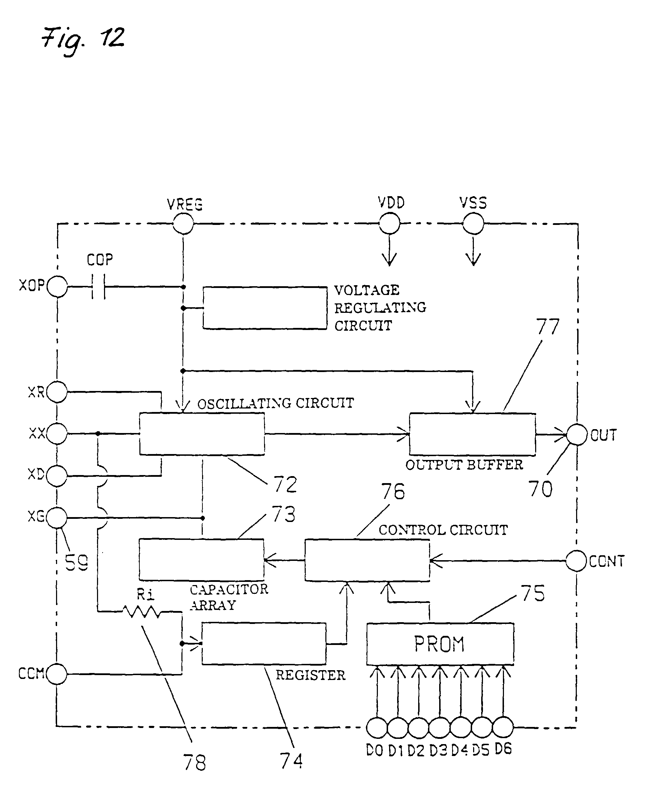

As shown in the circuit diagram of Figure 12, the IC chip 53 is a one-chip semiconductor device which includes an oscillating circuit 72, capacitor array 73, register 74, PROM 75, control circuit 76, output buffer 77, etc., and which is programmed to change the capacitance associated with the XG terminal 59 by controlling the capacitor array 73 according to frequency adjustment data and frequency dividing condition data provided by an external source thereby controlling the frequency of the oscillation based on the quartz oscillation wherein the oscillation signal is output via the OUT terminal 70.

The IC chip 53 also includes a resistor 78 which is connected to the node between a DC-blocking capacitor and the variable-capacitance diode 66 so that the resistor 78 serves as an input resistor of the VC terminal 71.

The lead frame constructed in the above-described manner is placed in a transfer mold and transfer-molded with resin except for outer portions of the inner lead electrodes 54 and the signal input lead terminals thereby obtaining a voltage-controlled oscillator.

The oscillation frequency is adjusted in a similar manner to the quartz-crystal oscillator described above. However, unlike the quartz-crystal oscillator in which the NC/OE terminal is used, the VC terminal 71 is used to adjust the oscillation frequency of the voltage-controlled oscillator.

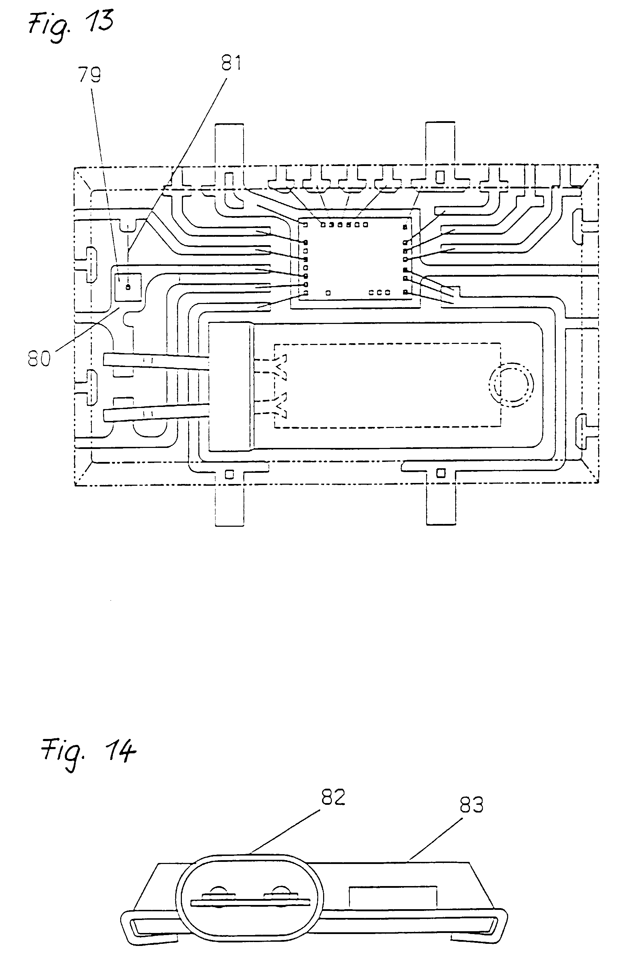

Figure 13 illustrates another embodiment of a voltage-controlled oscillator. A variable-capacitance diode 79 of the chip type is employed in this voltage-controlled oscillator. The variable-capacitance diode 79 is attached to the land 80 via a conductive adhesive or the like and an electrical connection is made via a wire-bonded gold wire 81.

The voltage-controlled oscillator constructed in the above-described manner has a thickness as small as about 2.0-2.2 mm and a volume as small as about 0.2 cc.

The cross-section of the quartz-crystal resonator has the special shape as described above. This ensures that the resin is coated uniformly in thickness around the quartz-crystal resonator. As a result, it is possible to improve the filling efficiency of the molding resin. Furthermore, the obtained voltage-controlled oscillator has no cracks in its package and thus shows high reliability.

In the voltage-controlled oscillator of the present embodiment, it is possible to change the oscillation frequency by an amount of ±20 ppm relative to the center frequency by changing the voltage applied to the VC terminal within the range from 1.2 V to 1.8 V.

### Method of further reducing the thickness

Figure 14 illustrates another embodiment in which a quartz-crystal resonator 82 having a cross-section of an elliptic shape or a track shape is disposed in a quartz-crystal oscillator or a voltage-controlled oscillator in such a manner that the quartz-crystal resonator 82 is partly exposed to the outside of a package 83.

This allows a further reduction in the thickness of the quartz-crystal oscillator or the voltage-controlled oscillator down to a value equal to the thickness of the quartz-crystal resonator itself or about 1.5 mm.

In this structure, the case of the quartz-crystal resonator is in direct contact with the ambient air. As a result, it is possible to remove heat more effectively from the IC chip thereby preventing the heat from expanding the quartz-crystal resonator.

### Technique of preventing deformation of the quartz-crystal resonator

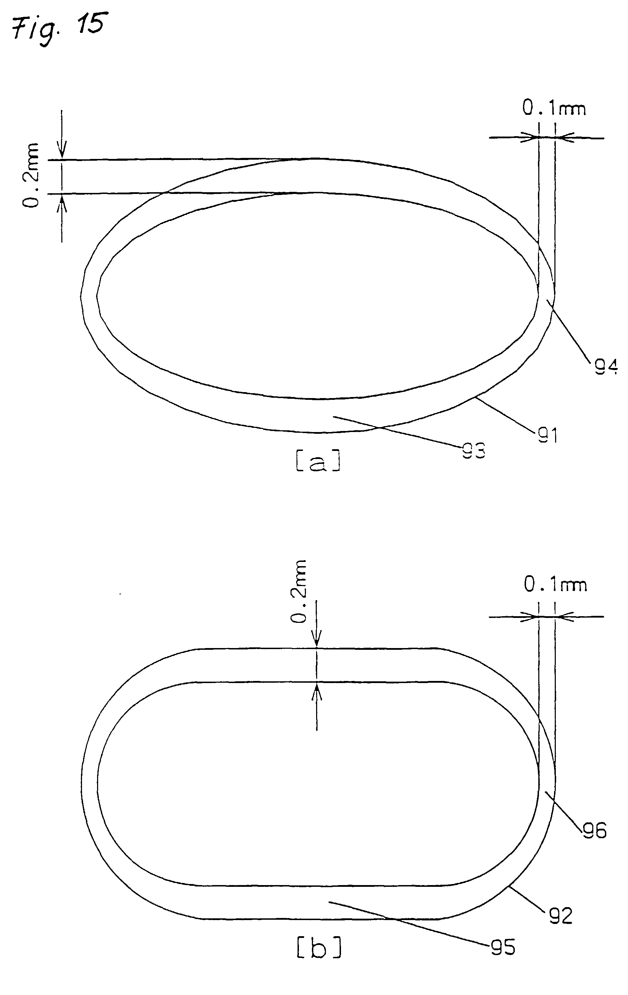

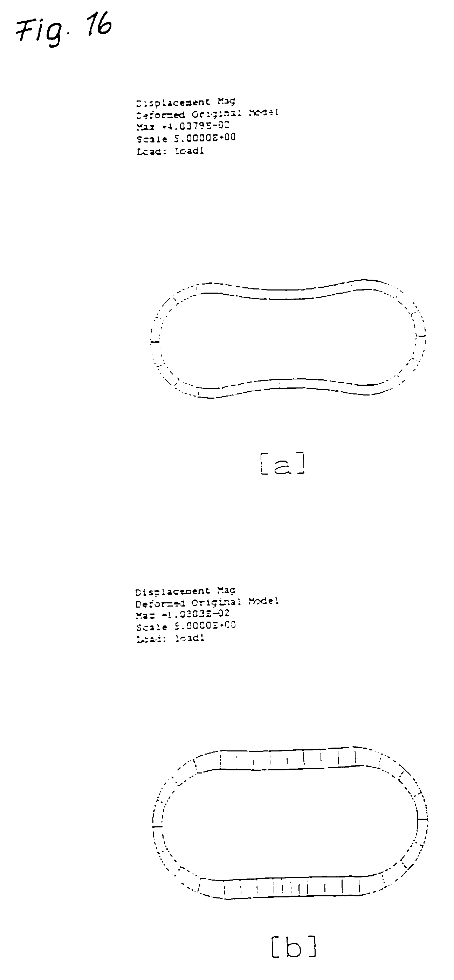

Figures 15 and 16 illustrate the shape of cases used for particular embodiments of a quartz-crystal resonator according to various aspects of the invention. The case 91 of the quartz-crystal resonator shown in Figure 15a has a cross-section of an elliptic shape, while the case 92 shown in Figure 15b has a cross-section of a track shape.

In the case 91 shown in Figure 15a, the thickness of the case wall is not constant. The thickness of the part of the case at location 93 parallel to the major axis of the ellipse is about 1.5 to 2 times greater than that of the part of the case at location 94 parallel to the minor axis. In this specific embodiment, the thickness of the case at 93 parallel to the major axis is in the range from 0.15 mm to 0.2 mm, and the thickness of the case at 94 parallel to the minor axis is about 0.1 mm.

In the case 92 shown in Figure 15b, the thickness of the case wall also is not constant. The thickness of a linear part of the case at location 95 is about 1.5 to 2 times greater than that of a curved part of the case at location 96. In this specific embodiment, the thickness of the linear part of the case at 95 is in the range from 0.15 mm to 0.2 mm, and the thickness of the curved part of the case at 96 is about 0.1 mm.

In these cases 91 and 92, the parts which are most apt to be deformed by the pressure of an injected molding resin have a thickness greater than the other parts so that the cases have enough mechanical strength against such pressure. This makes it possible to reduce the size of the case of the piezoelectric resonator to the smallest possible thickness. These structures also reduce the amount of material in the case, and thus results in a reduction in the cost.

A computer analysis using structural analysis software has indicated that the deformation of the cases of the present invention is as small as a quarter or less of that of conventional cases. Figure 16 illustrates the result of the structural analysis for the case 92 having a cross-section of a track shape. In this analysis, the deformation of the case which occurs when a pressure is uniformly applied against the outer surface of the case is calculated. For the purpose of comparison, the result for the conventional case is shown in Figure 16a while the result for the case of the present invention is shown in Figure 16b.

It can be seen from the results of this computer analysis that, if the case is formed into either shape according to the present invention, it is possible to reduce the deformation of the case. For example, the deformation of an elliptical case such as case 91 at is reduced at location 93 and the deformation of a track-shaped case such as case 92 is reduced at location 95. This means that a case having a shape according to the invention can improve the reliability of the piezoelectric oscillator and voltage-controlled oscillator.

Table 1 illustrates the characteristics of a molding resin employed for a piezoelectric oscillator or voltage-controlled oscillator according to various aspects of the invention. The molding resin employed herein has a bending strength of about 2.5 kg/mm² (25 MPa) at a high temperature of 240°C to 260°C, which is much higher than the bending strength of 1.2 kg/mm² to 1.5 kg/mm² (12 MPa to 15 MPa) for conventional molding resins. The molding resin having such a high bending strength ensures that the piezoelectric oscillator and voltage-controlled oscillator can withstand the reflowing stress which occurs when they are mounted on a circuit board. In particular, when the cross-section of the piezoelectric resonator has an elliptic shape or a track-like shape as in the present invention and the case of the piezoelectric resonator is in contact with the resin over a large contact area, separation often occurs at the interface between the case and the resin during a reflowing process or cracks are often produced in the package. The molding resin having a high bending strength according to the present invention is effective to prevent such problems.

**Table 1**

| ITEM | MOLDING MATERIAL (Invention) | MOLDING MATERIAL (conventional) |
|---|---|---|
| Relative Density | 2.00 | 1.82 |
| Bending Strength | 20 kg/mm² (196 MPa) | 12 kg/mm² (118 MPa) |
| Instantaneous Bending Strength | 2.5 kg/mm² (25 MPa) | 1.3 kg/mm² (13 MPa) |
| Bending Modulus | 2400 kg/mm² (23.5 x 10³ MPa) | 1200 kg/mm² (11.8 x 10³ MPa) |
| Instantaneous Bending Modulus | 86.5 kg/mm² (848 MPa) | 100 kg/mm² (981 MPa) |
| Glass-Transition Temp. | 150 °C | 165 °C |
| Coeff.of thermal Expansion | 1.0 x 10⁻⁵ | 1.7 x 10⁻⁵ |

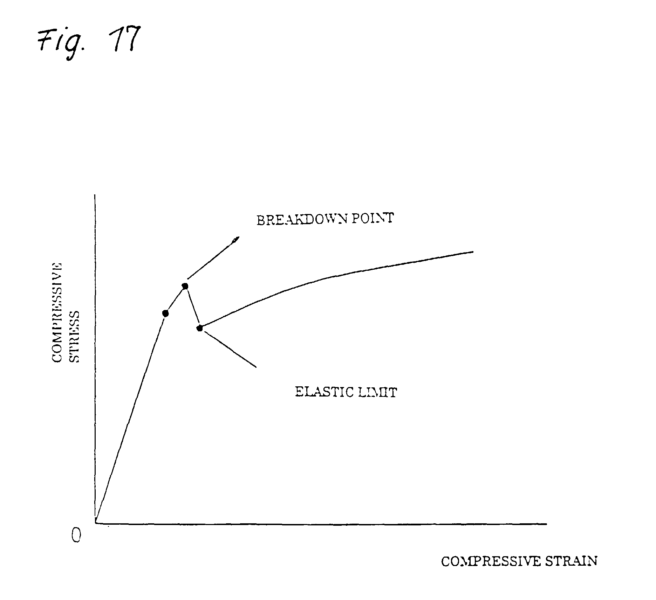

Figure 17 is a graph illustrating the deformation of the case of the quartz-crystal resonator caused by the injection pressure during a molding process. This graph is a plot of compressive stress (injection pressure) versus strain. As can be seen from this plot, if deformation occurs during a molding process, the deformed shape returns to the original shape when the molding process has been completed, as long as the case is deformed within the elastic deformation range (below the elastic limit) shown in Figure 17. However, if the case is deformed beyond the elastic limit, the deformed shape no longer returns to the original shape. In this embodiment, the injection pressure is controlled within the elastic deformation range taking into account the characteristics of a transfer molding machine and the structure of a mold used. For example, the pressure at the ram of the transfer molding machine is set to about 18 kg/cm² (177 MPa). Furthermore, in this embodiment, 42-alloy containing Fe and Ni is employed as the material for the case, and the molding pressure is optimized taking into account the stress-strain characteristic of this material.

As described above, the molding process is performed in such a manner that the deformation of the case falls within the elastic deformation range thereby preventing the case from deformation that will remain permanently.

In the embodiment described above, it is assumed that a SOJ-type package is employed as the package of the piezoelectric oscillator and voltage-controlled oscillator. However, the invention is not limited to this type of package. Other types of packages, such as a SOP (small outline package) may also be employed.

The various aspects of the invention may be summarized as follows:

In a 1st aspect of the present invention, there is provided a piezoelectric oscillator including a semiconductor integrated circuit and a piezoelectric resonator, characterized in that: the semiconductor integrated circuit is mounted on an island of a lead frame, the semiconductor integrated circuit being electrically connected to an inner lead electrode of the lead frame via a wire-bonded wire; the piezoelectric resonator having a cross-section of an elliptic shape or a track shape (combination of a rectangle and two semicircles) is disposed adjacent to the semiconductor integrated circuit; a lead of the piezoelectric resonator is electrically connected to a part of the lead frame; there is also provided a signal input lead terminal electrically connected to the semiconductor integrated circuit so that data in the semiconductor integrated circuit is controlled via the signal input lead terminal; the semiconductor integrated circuit, the piezoelectric resonator, and the lead frame are molded with a resin into a single unit in such a manner that the outer part of the inner lead electrode and the signal input lead terminal are exposed to the outside; and the oscillation frequency is adjusted by applying a signal to the piezoelectric oscillator via the signal input lead terminal. Thus, a small-sized piezoelectric oscillator of the surface mounting type can be obtained. This piezoelectric resonator is covered with a resin having a uniform thickness. This means that it is possible to supply a molding resin uniformly during a molding process. As a result, it is possible to produced a high-reliability piezoelectric oscillator having no cracks in its package.

In a 2nd aspect of the invention, based on the 1st aspect described above, the piezoelectric oscillator is molded with the resin in such a manner that the thickness of the resin disposed on the upper side of the piezoelectric resonator is equal to that on the lower side of the piezoelectric resonator. This ensures that a uniform pressure is applied to the case of the piezoelectric resonator during the molding process and thus the deformation of the case of the piezoelectric resonator is prevented. Furthermore, it is possible to supply a molding resin uniformly during a molding process, and thus the piezoelectric resonator is covered with a resin having a uniform thickness. Therefore, it is possible to produced a high-reliability piezoelectric oscillator having no cracks in its package.

In a 3rd aspect of the invention, based on the 1st aspect described above, the surface of the case of the piezoelectric resonator is exposed to the outside of the piezoelectric oscillator. This makes it possible to obtain a piezoelectric oscillator having a very small thickness. This structure is also effective to remove the heat generated in the piezoelectric oscillator.

In a 4th aspect of the invention, based on the 1st aspect described above, when an ellipse is employed as the shape of the cross-section of the case of the piezoelectric resonator, the case is formed so that parts of the case along the major axis of the ellipse have a wall thickness greater than the other parts, while when a track-like shape is employed as the shape of the cross-section of the case of the piezoelectric resonator, the case is formed so that linear parts of the case have a wall thickness greater than the other parts. This ensures that the case is deformed to a much less extent than conventional cases. Therefore, the molding process can be performed without imposing any influence on the inside of the case of the piezoelectric resonator, and thus the production yield is improved.

In a 5th aspect of the invention, based on the 1st aspect described above, the piezoelectric oscillator is molded with a molding resin having a bending strength greater than 2 kg/mm² (20 MPa) at a high temperature of 240°C to 260°C. This makes it possible to produce a piezoelectric oscillator without having either separation at the interface between the case and the resin or cracks in the package during a reflowing process. Thus the obtained piezoelectric oscillator shows high quality and high reliability.

In a 6th aspect of the invention, based on the 1st aspect described above, the lead frame is provided with a supporting lead terminal for supporting the piezoelectric oscillator molded with the resin into the single unit. This allows measurement of electrical characteristics and adjustment of the frequency to be performed on the piezoelectric oscillator without having to separate it from the lead frame. Thus, the adjustment and measurement process can be incorporated into the production line.

In a 7th aspect of the invention, based on the 1st or 6th aspect described above, the signal input lead terminals used to control the data in the semiconductor integrated circuit are disposed in a line perpendicular to the major axis of the piezoelectric resonator at locations at the side of the semiconductor integrated circuit opposite to the piezoelectric resonator. This allows a reduction in the size of the piezoelectric oscillator to a very small thickness. Furthermore, since signal input lead terminals are disposed in a line on a side of the package, it is very easy to adjust the oscillation frequency.

In a 8th aspect of the invention, based on the 7th aspect described above, input/output pads are formed in peripheral areas on only three sides of the semiconductor integrated circuit in such a manner that no pads are formed on the side facing the piezoelectric resonator. This allows a reduction in the size of the piezoelectric oscillator to a very small thickness.

In a 9th aspect of the invention based on the 1st aspect described above, the piezoelectric resonator is a quartz-crystal resonator. This makes it possible to produce a small-sized piezoelectric oscillator having high performance and high reliability at a low cost.

In a 10th aspect of the invention, there is provided a method of producing a piezoelectric oscillator, including the steps of: mounting a semiconductor integrated circuit on an island of a lead frame and performing wire-bonding so that the semiconductor integrated circuit is electrically connected to an inner lead electrode of the lead frame via a wire-bonded wire; positioning a piezoelectric resonator on the lead frame so that the piezoelectric resonator is disposed adjacent to the semiconductor integrated circuit, and then electrically connecting the lead of the piezoelectric resonator to a part of the lead frame; molding the semiconductor integrated circuit, the piezoelectric resonator, and the lead frame with a resin into a single unit in such a manner that the outer part of the inner lead electrode and the signal input lead terminal are exposed to the outside; cutting off tie-bars connecting the outer part of the inner lead electrode and the signal input lead terminal; applying a signal to the signal input lead terminal thereby adjusting the oscillation frequency; and bending the outer part of the inner lead electrode, and cutting the signal input lead terminal and the supporting lead terminal thereby separating the piezoelectric oscillator from the lead frame. The production according to this method can be performed using an existing production line. This means that it is possible to produce a small-sized piezoelectric oscillator having high reliability at a low cost.

In a 11th aspect of the invention, based on the 10th aspect described above, in the step of applying a signal to the signal input lead terminal thereby adjusting the oscillation frequency, data is applied via the signal input lead terminal and NC terminal or OE terminal. This allows the terminals to be shared by input and output signals.

In a 12th aspect of the invention, based on the 10th aspect described above, in the step of applying a signal to the signal input lead terminal thereby adjusting the oscillation frequency, the frequency is adjusted for a plurality of piezoelectric oscillators remaining connected to the lead frame. This makes it possible to adjust the frequency of a great number of piezoelectric oscillators at the same time. This allows a reduction in the time required for producing and evaluating the piezoelectric oscillators.

In a 13th aspect of the invention, there is provided a voltage-controlled oscillator including a semiconductor integrated circuit, a piezoelectric resonator, and another electronic component, characterized in that: the semiconductor integrated circuit is mounted on an island of a lead frame, the semiconductor integrated circuit being electrically connected to an inner lead electrode of the lead frame via a wire-bonded wire; the piezoelectric resonator having a cross-section of an elliptic shape or a track shape (combination of a rectangle and two semicircles) is disposed adjacent to the semiconductor integrated circuit; a lead of the piezoelectric resonator is electrically connected to a part of the lead frame; the electronic component is mounted on a land of the lead frame; there is provided a signal input lead terminal electrically connected to the semiconductor integrated circuit so that data in the semiconductor integrated circuit is controlled via the signal input lead terminal; the semiconductor integrated circuit, the piezoelectric resonator, the electronic component, and the lead frame are molded with a resin into a single unit in such a manner that the outer part of the inner lead electrode and the signal input lead terminal are exposed to the outside; and the oscillation frequency is adjusted by applying a signal to the piezoelectric oscillator via the signal input lead terminal. This makes it possible to obtain a voltage-controlled oscillator of the surface mounting type having a very small thickness. Furthermore, it is possible to supply a molding resin uniformly during a molding process, and thus the piezoelectric resonator is covered with a resin having a uniform thickness. Therefore, it is possible to produced a high-reliability voltage-controlled oscillator having no cracks in its package.

In a 14th aspect of the invention, based on the 13th aspect described above, the voltage-controlled oscillator is molded with the resin in such a manner that the thickness of the resin disposed on the upper side of the piezoelectric resonator is equal to that on the lower side of the piezoelectric resonator. This ensures that a uniform pressure is applied to the case of the piezoelectric resonator during the molding process and thus the deformation of the case of the piezoelectric resonator is minimized. Furthermore, it is possible to supply a molding resin uniformly during a molding process, and thus the piezoelectric resonator is covered with a resin having a uniform thickness. Therefore, it is possible to produced a high-reliability voltage-controlled oscillator having no cracks in its package.

In a 15th aspect of the invention, based on the 13th aspect described above, the surface of the case of the piezoelectric resonator is exposed to the outside of the voltage-controlled oscillator. This makes it possible to obtain a voltage-controlled oscillator having a very small thickness. This structure is also effective to remove the heat generated in the voltage-controlled oscillator.

In a 16th aspect of the invention, based on the 13th aspect described above, when an ellipse is employed as the shape of the cross-section of the case of the piezoelectric resonator, the case is formed so that parts of the case along the major axis of the ellipse have a wall thickness greater than the other parts, while when a track-like shape is employed as the shape of the cross-section of the case of the piezoelectric resonator, the case is formed so that linear parts of the case have a wall thickness greater than the other parts. This ensures that the case is deformed to a much less extent than conventional cases. Therefore, the molding process can be performed without imposing any influence on the inside of the case of the voltage-controlled oscillator and thus the production yield is improved.

In a 17th aspect of the invention, based on the 13th aspect described above, the voltage-controlled oscillator is molded with a molding resin having a bending strength greater than 2 kg/mm² (20 MPa) at a high temperature of 240°C to 260°C. This makes it possible to produce a voltage-controlled oscillator without having either separation at the interface between the case and the resin or cracks in the package during a reflowing process. Thus the obtained voltage-controlled oscillator shows high quality and high reliability.

In a 18th aspect of the invention, based on the 13th aspect described above, the lead frame is provided with a supporting lead terminal for supporting the voltage-controlled oscillator molded with the resin into the single unit. This allows measurement of electrical characteristics and adjustment of the frequency to be performed on the voltage-controlled oscillator without having to separate it from the lead frame. Thus, the adjustment and measurement process can be incorporated into the production line.

In a 19th aspect of the invention, based on the 13th or 18th aspect described above, the signal input lead terminals used to control the data in the semiconductor integrated circuit are disposed in a line in parallel to the piezoelectric resonator at locations at the side of the semiconductor integrated circuit opposite to the piezoelectric resonator. This allows a reduction in the size of the voltage-controlled oscillator to a very small thickness. Furthermore, signal input lead terminals are disposed in a line on a side of the package, and thus it is very easy to adjust the oscillation frequency.

In a 20th aspect of the invention, based on the 19th aspect described above, input/output pads are formed in peripheral areas on only three sides of the semiconductor integrated circuit in such a manner that no pads are formed on the side facing the piezoelectric resonator. This allows a reduction in the size of the voltage-controlled oscillator to a very small thickness.

In a 21st aspect of the invention, based on the 13th aspect described above, the piezoelectric resonator is a quartz-crystal resonator. This makes it possible to produce a small-sized voltage-controlled oscillator having high performance and high reliability at a low cost.

In a 22nd aspect of the invention, based on the 13th aspect described above, the electronic component is a variable-capacitance diode. This makes it possible to provide a small-sized voltage-controlled oscillator having high performance and high reliability.

In a 23rd aspect of the invention, there is provide a method of producing a voltage-controlled oscillator, including the steps of: mounting a semiconductor integrated circuit on an island of a lead frame and performing wire-bonding so that the semiconductor integrated circuit is electrically connected to an inner lead electrode of the lead frame via a wire-bonded wire; positioning a piezoelectric resonator on the lead frame so that the piezoelectric resonator is disposed adjacent to the semiconductor integrated circuit, and then electrically connecting the lead of the piezoelectric resonator to a part of the lead frame; mounting an electronic component on a land formed in the lead frame; molding the semiconductor integrated circuit, the piezoelectric resonator, the electronic component, and the lead frame with a resin into a single unit in such a manner that the outer part of the inner lead electrode and the signal input lead terminal are exposed to the outside; cutting off tie-bars connecting the outer part of the inner lead electrode and the signal input lead terminal; applying a signal to the signal input lead terminal thereby adjusting the oscillation frequency; and bending the outer part of the inner lead electrode, and cutting the signal input lead terminal and the supporting lead terminal thereby separating the voltage-controlled oscillator from the lead frame. The production according to this method can be performed using an existing production line. This means that it is possible to produce a small-sized voltage-controlled oscillator having high reliability at a low cost.

In a 24th aspect of the invention, based on the 23rd aspect described above, in the step of applying a signal to the signal input lead terminal thereby adjusting the oscillation frequency, data is applied via the signal input lead terminal and VC terminal. This allows the terminals to be shared by input and output signals.

In a 25th aspect of the invention, based on the 23rd aspect described above, in the step of applying a signal to the signal input lead terminal thereby adjusting the oscillation frequency, the frequency is adjusted for a plurality of voltage-controlled oscillators remaining connected to the lead frame. This allows a reduction in the time required for producing and evaluating the voltage-controlled oscillator.

In a 26th aspect of the invention, based on the 22nd aspect described above, the piezoelectric resonator and the variable-capacitance diode are connected in series between the input and output terminals of an inverter of the semiconductor integrated circuit; a DC-blocking capacitor is disposed between the variable-capacitance diode and the inverter; the node between the piezoelectric resonator and the variable-capacitance diode is connected to ground via a bias resistor; and a signal is applied to the node between the variable-capacitance diode and the DC-blocking capacitor. This allows the oscillation frequency of the voltage-controlled oscillator to be varied over a wider range than conventional voltage-controlled oscillators. The wide range in the variation of the frequency is due to the phase difference between the terminals of the variable-capacitance diode.

## Claims

1. A piezoelectric oscillator comprising:
a lead frame (1),
a semiconductor integrated circuit (3) mounted on a mounting pad (2) of said lead frame (1) and electrically connected to leads (4) of said lead frame (1) via wire-bonded wires (5),
a piezoelectric resonator (7) having a case (38) with a cross-section of an elliptic shape or an oblong shape with semicircular end portions and disposed adjacent to said semiconductor integrated circuit (3), wherein leads (8) of said piezoelectric resonator (7) are electrically connected to a part (12a, 12b) of said lead frame (1) and said semiconductor integrated circuit (3) is adapted to store control data for controlling the oscillation frequency of said piezoelectric resonator (7)
a signal input lead terminal (14-21) is electrically connected to said semiconductor integrated circuit (3) so that said data stored in said semiconductor integrated circuit may be changed via said signal input lead terminal such that said oscillation frequency is adjustable by a signal applied to said signal input lead terminal; and
said semiconductor integrated circuit (3), said piezoelectric resonator (7), and said lead frame (1) are molded with resin to a single unit in such a manner that a part of each of said leads (4) and said signal input lead terminal are exposed to the outside of said molded unit.

2. A piezoelectric oscillator according to claim 1, wherein said single unit is molded with a resin in such a manner that the thickness of the resin disposed on the upper side of the case (38) of said piezoelectric resonator (7) is equal to that on the lower side of the case of said piezoelectric resonator (7).

3. A piezoelectric oscillator according to claim 1, wherein the surface of the case (38) of said piezoelectric resonator (7) is exposed to the outside of said single unit.

4. A piezoelectric oscillator according to any one of claims 1 through 3, wherein portions of said case (38) along the major axis of said elliptic shape or linear parts of said oblong shape with semicircular end portions of said case (38) have a greater thickness than the other portions of the case.

5. A piezoelectric oscillator according to any one of claims 1 through 4, wherein said single unit is molded with a molding resin having a bending strength greater than 2 kg/mm² (20 MPa) at a high temperature of 240°C to 260°C.

6. A piezoelectric oscillator according to any one of claims 1 through 5, wherein multiple signal input lead terminals (14-21) connected to said semiconductor integrated circuit (3) are provided, said signal input lead terminals are disposed in a line parallel to the major dimension of said piezoelectric resonator (7) at the side of said semiconductor integrated circuit (3) opposite to said piezoelectric resonator (7).

7. A piezoelectric oscillator according to any one of claims 1 through 6, wherein input/output pads are formed in peripheral areas on three sides of said semiconductor integrated circuit (3) in such a manner that no pads are formed on the side facing said piezoelectric resonator (7).

8. A piezoelectric oscillator according to any one of claims 1 through 7, wherein said piezoelectric resonator (7) is a quartz-crystal resonator.

9. A method of producing a piezoelectric oscillator, comprising the steps of:
(a) mounting a semiconductor integrated circuit (3) on a mounting pad of a lead frame (1) and performing wire-bonding so that said semiconductor integrated circuit (3) is electrically connected to leads (4) of said lead frame via wire-bonded wires (5) and is electrically connected to a signal input lead terminal(14-21);
(b) positioning a piezoelectric resonator (7) on said lead frame (1) so that said piezoelectric resonator (7) is disposed adjacent to said semiconductor integrated circuit (3), and then electrically connecting the leads (8) of said piezoelectric resonator (7) to a part (12a, 12b) of said lead frame (1);
(c) molding said semiconductor integrated circuit (3), said piezoelectric resonator (7), and said lead frame with resin into a single unit in such a manner that part of each lead and said signal input lead terminal are exposed to the outside of the molded unit;
(d) cutting off tie-bars connecting the exposed part of said leads and said signal input lead terminal; and
(e) applying a signal to said signal input lead terminal (14-21) thereby adjusting the oscillation frequency of said piezoelectric resonator (7).

10. A method according to claim 9, wherein, in step (e), data is applied via said signal input lead terminal (14-21) and an NC terminal or OE terminal (25).

11. A method according to claim 9 or 10, wherein, in step (e), the frequency is adjusted for a plurality of piezoelectric oscillators (13) remaining connected to said lead frame (1).

12. The oscillator according to any one of claims 1 to 8 further including another electronic component (66) mounted on another mounting pad (67) of said lead frame (1), wherein said semiconductor integrated circuit (3), said piezoelectric resonator (7), said electronic component (66) and said lead frame (1) are molded to said single unit forming a voltage-controlled oscillator.

13. The oscillator, according claim 12 wherein said electronic component (66) is a variable-capacitance diode.

14. The oscillator according to claim 13, wherein
said piezoelectric resonator (7) and said variable-capacitance diode (66) are connected in series between the input and output terminals of an inverter of said semiconductor integrated circuit (3);
a DC- blocking capacitor is disposed between said variable-capacitance diode (66) and said inverter;
the node (XR) between said piezoelectric resonator (7) and said variable-capacitance diode (66) is connected to ground via a bias resistor; and
a control terminal is connected to the node (XX) between said variable-capacitance diode and said DC-blocking capacitor, whereby the oscillation frequency of said voltage-controlled oscillator may be controlled by a voltage applied to said control terminal.

15. A method according to any one of claims 9 to 11 for producing a voltage-controlled oscillator, further comprising:
(f) mounting an electronic component (66) on another mounting pad (67) of said lead frame (61);
wherein step (c) comprises molding said semiconductor integrated circuit (3), said piezoelectric resonator (7), said electronic component (66), and said lead frame with resin into a single unit; and
step (e) comprises adjusting the oscillation frequency of said voltage-controlled oscillator.

16. A method according to claim 15, wherein, in step (e), data is applied via said signal input lead terminal and a VC terminal.

17. A method to claim 15 or 16, wherein, in step (e), the frequency is adjusted for a plurality of voltage-controlled oscillators remaining connected to said lead frame (1).

## Patentansprüche

1. Piezoelektrischer Oszillator, umfassend:
einen Leiterrahmen (1),
einen Halbleiter-IC (3), der auf einer Montagefläche (2) des Leiterrahmens (1) montiert und über drahtgebondete Drähte (5) an Leitungen (4) des Leiterrahmens (1) elektrisch angeschlossen ist,
einen piezoelektrischen Resonator (7), der ein Gehäuse (38) mit einem Querschnitt in einer elliptischen Form oder einer länglichen Form mit halbkreisförmigen Endabschnitten aufweist und dem Halbleiter-IC (3) benachbart angeordnet ist,
wobei Leitungen (8) des piezoelektrischen Resonators (7) an einen Teil (12a, 12b) des Leiterrahmens (1) elektrisch angeschlossen sind und der Halbleiter-IC (3) ausgebildet ist, Steuerdaten zum Steuern der Oszillationsfrequenz des piezoelektrischen Resonators (7) zu speichern,
ein Signaleingangsleitungsanschluß (14 - 21) an den Halbleiter-IC (3) elektrisch angeschlossen ist, so daß die im Halbleiter-IC gespeicherten Daten über den Signaleingangsleitungsanschluß derart geändert werden können, daß die Oszillationsfrequenz durch ein an den Signaleingangsleitungsanschluß angelegtes Signal einstellbar ist; und
der Halbleiter-IC (3), der piezoelektrische Resonator (7) und der Leiterrahmen (1) mit Harz derart zu einer einzigen Einheit vergossen sind, daß ein Teil jeder der Leitungen (4) und des Signaleingangsleitungsanschlusses zur Außenseite der vergossenen Einheit freiliegen.

2. Piezoelektrischer Oszillator nach Anspruch 1, bei dem die einzige Einheit durch ein Harz derart vergossen ist, daß die Dicke des an der Oberseite des Gehäuses (38) des piezoelektrischen Resonators (7) angeordneten Harzes gleich derjenigen an der Unterseite des Gehäuses des piezoelektrischen Resonators (7) ist.

3. Piezoelektrischer Oszillator nach Anspruch 1, bei dem die Oberfläche des Gehäuses (38) des piezoelektrischen Resonators (7) zur Außenseite der einzigen Einheit freiliegt.

4. Piezoelektrischer Oszillator nach einem der Ansprüche 1 bis 3, bei dem Abschnitte des Gehäuses (38) längs der Hauptachse der elliptischen Form oder linearer Teile der länglichen Form mit halbkreisförmigen Endabschnitten des Gehäuses (38) eine größere Dicke als die anderen Abschnitte des Gehäuses aufweisen.

5. Piezoelektrischer Oszillator nach einem der Ansprüche 1 bis 4, bei dem die einzige Einheit mit einem Vergußharz mit einer Biegefestigkeit von mehr als 2 kg/mm² (20 MPa) bei einer hohen Temperatur von 240°C bis 260°C vergossen ist.

6. Piezoelektrischer Oszillator nach einem der Ansprüche 1 bis 5, bei dem mehrere Signaleingangsleitungsanschlüsse (14 - 21) vorgesehen sind, die an den Halbleiter-IC (3) angeschlossen sind, und die Signaleingangsleitungsanschlüsse in einer Linie parallel zur Hauptabmessung des piezoelektrischen Resonators (7) an der Seite des Halbleiter-ICs (3) angeordnet sind, die vom piezoelektrischen Resonator (7) abgewandt ist.

7. Piezoelektrischer Oszillator nach einem der Ansprüche 1 bis 6, bei dem Eingangs/Ausgangsanschlußflächen in peripheren Bereichen an drei Seiten des Halbleiter-ICs (3) so gebildet sind, daß keine Anschlußflächen auf der Seite gebildet sind, die dem piezoelektrischen Resonator (7) zugewandt ist.

8. Piezoelektrischer Oszillator nach einem der Ansprüche 1 bis 7, bei dem der piezoelektrische Resonator (7) ein Quarzkristallresonator ist.

9. Verfahren zur Herstellung eines piezoelektrischen Oszillators, umfassend folgende Schritte:
(a) Montieren eines Halbleiter-ICs (3) auf einer Montagefläche eines Leiterrahmens (1) und Ausführen einer Drahtbondierung derart, daß der Halbleiter-IC (3) über drahtgebondete Drähte (5) an Leitungen (4) des Leiterrahmens elektrisch angeschlossen und an einen Signaleingangsleitungsanschluß (14 - 21) elektrisch angeschlossen ist;
(b) Positionieren eines piezoelektrischen Resonators (7) auf dem Leiterrahmen (1) derart, daß der piezoelektrische Resonator (7) dem Halbleiter-IC (3) benachbart angeordnet ist, und anschließendes elektrisches Anschließen der Leitungen (8) des piezoelektrischen Resonators (7) an einen Teil (12a, 12b) des Leiterrahmens (1);
(c) Vergießen des Halbleiter-ICs (3), des piezoelektrischen Resonators (7) und des Leiterrahmens mit Harz zu einer einzigen Einheit derart, daß ein Teil jeder Leitung und des Signaleingangsleitungsanschlusses zur Außenseite der vergossenen Einheit freiliegt;
(d) Abschneiden von Verbindungsstegen, welche den freiliegenden Teil der Leitungen und des Signaleingangsleitungsanschlusses verbinden; und
(e) Anlegen eines Signals an den Signaleingangsleitungsanschluß (14 - 21), wodurch die Oszillationsfrequenz des piezoelektrischen Resonators (7) eingestellt wird.

10. Verfahren nach Anspruch 9, bei dem in Schritt (e) Daten über den Signaleingangsleitungsanschluß (14 - 21) und einen NC-Anschluß oder einen OE-Anschluß (25) angelegt werden.

11. Verfahren nach Anspruch 9 oder 10, bei dem in Schritt (e) die Frequenz für eine Mehrzahl von piezoelektrischen Oszillatoren (13) eingestellt wird, die mit dem Leiterrahmen (1) verbunden bleiben.

12. Oszillator nach einem der Ansprüche 1 bis 8, der außerdem eine weitere elektronische Komponente (66) enthält, die auf einer anderen Montagefläche (67) des Leiterrahmens (1) montiert ist, wobei der Halbleiter-IC (3), der piezoelektrische Resonator (7), die elektronische Komponente (66) und der Leiterrahmen (1) zu einer einzigen Einheit vergossen sind, die einen spannungsgesteuerten Oszillator bildet.

13. Oszillator nach Anspruch 12, bei dem die elektronische Komponente (66) eine Kapazitätsdiode ist.

14. Oszillator nach Anspruch 13, bei dem
der piezoelektrische Resonator (7) und die Kapazitätsdiode (66) in Serie zwischen den Eingangs- und den Ausgangsanschluß eines Inverters des Halbleiter-ICs (3) geschaltet sind;
ein Gleichstromsperrkondensator zwischen der Kapazitätsdiode (66) und dem Inverter angeordnet ist;
der Knoten (XR) zwischen dem piezoelektrischen Resonator (7) und der Kapazitätsdiode (66) über einen Vorspannungswiderstand mit Erde verbunden ist; und
ein Steueranschluß an den Knoten (XX) zwischen der Kapazitätsdiode und dem Gleichstromsperrkondensator angeschlossen ist, wodurch die Oszillationsfrequenz des spannungsgesteuerten Oszillators durch eine an den Steueranschluß angelegte Spannung gesteuert werden kann.

15. Verfahren nach einem der Ansprüche 9 bis 11 zur Herstellung eines spannungsgesteuerten Oszillators, ferner umfassend:
(f) Montieren einer elektronischen Komponente (66) auf einer anderen Montagefläche (67) des Leiterrahmens (61);
wobei Schritt (c) das Vergießen des Halbleiter-ICs (3), des piezoelektrischen Resonators (7), der elektronischen Komponente (66) und des Leiterrahmens mit Harz zu einer einzigen Einheit umfaßt; und
Schritt (e) das Einstellen der Oszillationsfrequenz des spannungsgesteuerten Oszillators umfaßt.

16. Verfahren nach Anspruch 15, bei dem in Schritt (e) Daten über den Signaleingangsleitungsanschluß und einen VC-Anschluß angelegt werden.

17. Verfahren nach Anspruch 15 oder 16, bei dem in Schritt (e) die Frequenz für eine Mehrzahl spannungsgesteuerter Oszillatoren eingestellt wird, die mit dem Leiterrahmen (1) verbunden bleiben.

## Revendications

1. Oscillateur piézo-électrique comprenant :
une grille (1) de connexion,
un circuit (3) intégré à semi-conducteur monté sur une plage (2) de montage de la grille (1) de connexion et relié électriquement à des conducteurs (4) de la grille (1) de connexion par l'intermédiaire de fils (5) soudés,
un résonateur (7) piézo-électrique ayant un boîtier (8) dont la section transversale a une forme elliptique ou une forme oblongue en ayant des parties d'extrémité semi-circulaires et est adjacent au circuit (3) intégré à semi-conducteur, des conducteurs (8) du résonateur (7) piézo-électrique étant reliés électriquement à une partie (12a, 12b) de la grille (1) de connexion et le circuit (3) intégré à semi-conducteur étant apte à mémoriser des données de commande pour commander la fréquence d'oscillation du résonateur (7) piézo-électrique
une borne (14 à 21) d'entrée de signal est connectée électriquement au circuit (3) intégré à semi-conducteur de sorte que les données mémorisées dans le circuit intégré à semi-conducteur puissent être modifiées par la borne d'entrée de signal de façon à pouvoir ajuster la fréquence d'oscillation par un signal appliqué à la borne d'entrée du signal ; et
le circuit (3) intégré à semi-conducteur, le résonateur (7) piézo-électrique et la grille (1) de connexion sont enrobés à l'aide d'une résine en une unité unique d'une façon telle qu'une partie de chacun des conducteurs (4) et de la borne d'entrée du signal soit exposée à l'extérieur de l'unité enrobée.

2. Oscillateur piézo-électrique suivant la revendication 1, dans lequel l'unité unique est enrobée à l'aide de résine de telle façon que l'épaisseur de la résine disposée sur la face supérieure du boîtier (38) du résonateur (7) piézo-électrique est égale à celle se trouvant sur la face inférieure du boîtier du résonateur (7) piézo-électrique.

3. Oscillateur piézo-électrique suivant la revendication 1, dans lequel la surface du boîtier (38) du résonateur (7) piézo-électrique est exposée à l'extérieur de l'unité unique.

4. Oscillateur piézo-électrique suivant l'une quelconque des revendications 1 à 3, dans lequel la partie du boîtier (38) le long du grand axe de la forme elliptique ou les parties linéaires de la forme oblongue ayant des parties d'extrémité semi-circulaires du boîtier (38) ont une épaisseur plus grande que les autres parties du boîtier.

5. Oscillateur piézo-électrique suivant l'une quelconque des revendications 1 à 4, dans lequel l'unité unique est enrobée à l'aide d'une résine de moulage ayant une résistance à la flexion supérieure à 2 kg/mm² (20 MPa) à une haute température de 240°C à 260°C.

6. Oscillateur piézo-électrique suivant l'une quelconque des revendications 1 à 5, dans lequel il est prévu des bornes (14 à 21) multiples d'entrée de signal reliées au circuit (3) intégré à semi-conducteur, les bornes d'entrée de signal étant disposées suivant une ligne parallèle à la dimension principale du résonateur (7) piézo-électrique sur la face du circuit (3) intégré à semi-conducteur opposée au résonateur (7) piézo-électrique.

7. Oscillateur piézo-électrique suivant l'une quelconque des revendications 1 à 6, dans lequel des plages d'entrée/sortie sont formées dans des zones périphériques sur trois faces du circuit (3) intégré à semi-conducteur de sorte qu'aucune plage n'est formée sur la face faisant face au résonateur (7) piézo-électrique.

8. Oscillateur piézo-électrique suivant l'une quelconque des revendications 1 à 7, dans lequel le résonateur (7) piézo-électrique est un résonateur (7) à cristal de quartz.

9. Procédé de fabrication d'un oscillateur piézo-électrique qui consiste :
(a) à monter un circuit (3) intégré à semi-conducteur sur une plage de montage d'une grille (1) de connexion et à effectuer un soudage de fil de façon que le circuit (3) intégré à semi-conducteur soit relié électriquement à des conducteurs (4) de la grille de connexion par l'intermédiaire de fils (5) soudés et soit connecté électriquement à une borne (14 à 21) d'entrée de signal ;
(b) à mettre un résonateur (7) piézo-électrique en position sur la grille (1) de connexion de façon que le résonateur (7) piézo-électrique soit adjacent au circuit (3) intégré à semi-conducteur, puis à connecter électriquement les conducteurs (8) du résonateur (7) piézo-électrique à une partie (12a, 12b) de la grille (1) de connexion;
(c) à enrober le circuit (3) intégré à semi-conducteur, le résonateur (7) piézo-électrique et la grille de connexion à l'aide de résine en une unité unique de façon qu'une partie de chaque conducteur et de la borne d'entrée du signal soit exposée à l'extérieur de l'unité enrobée ;
(d) à déconnecter des barres de connexion connectant la partie exposée des conducteurs et de la borne d'entrée du signal ;
(e) à appliquer un signal à la borne (14 à 21) d'entrée du signal de manière à ajuster la fréquence d'oscillation du résonateur (7) piézo-électrique.

10. Procédé suivant la revendication 9, dans lequel, au stade (e), il est appliqué des données par l'intermédiaire de la bome (14 à 21) d'entrée du signal et d'une borne NC ou d'une borne (25) OE.

11. Procédé suivant la revendication 9 ou 10, dans lequel, au stade (e), la fréquence est ajustée pour une pluralité d'oscillateurs (13) piézo-électriques restant reliés à la grille (1) de connexion.

12. Oscillateur suivant l'une quelconque des revendications 1 à 8, comprenant en outre un autre composant (66) électronique monté sur une autre plage (67) de montage de la grille (1) de connexion, le circuit (3) intégré à semi-conducteur, le résonateur (7) piézo-électrique, le composant (66) électronique et la grille (1) de connexion étant enrobés en une unité unique formant un oscillateur commandé en tension.

13. Oscillateur suivant la revendication 12, dans lequel le composant (66) électronique est une diode à capacité variable.

14. Oscillateur suivant la revendication 13, dans lequel
le résonateur (7) piézo-électrique et la diode (66) à capacité variable sont montés en série entre les bornes d'entrée et de sortie d'un inverseur du circuit (3) intégré à semi-conducteur ;
un condensateur d'arrêt du courant continu est interposé entre la diode (66) à capacité variable et l'inverseur ;
le noeud (XR) entre le résonateur (7) piézo-électrique et la diode (66) à capacité variable est mis à la terre par l'intermédiaire d'une résistance de polarisation ; et
une borne de commande est reliée au noeud (XX) entre la diode à capacité variable et le condensateur d'arrêt du courant continu, de sorte que la fréquence d'oscillation de l'oscillateur commandé en tension peut être commandée par une tension appliquée à la borne de commande.

15. Procédé suivant l'une quelconque des revendications 9 à 11 de fabrication d'un oscillateur commandé en tension, comprenant en outre :
(f) le montage d'un constituant (66) électronique sur une autre plage (67) de montage de la grille (61) de connexion;
le stade (c) comprenant l'enrobage du circuit (3) intigré à semi-conducteur, du résonateur (7) piézo-électrique, du composant (66) électronique et de la grille de connexion à l'aide de résine en unité unique ; et
le stade (e) comprenant l'ajustement de la fréquence d'oscillation de l'oscillateur commandé en tension.

16. Procédé suivant la revendication 15, dans lequel, au stade (e), on applique des données par l'intermédiaire de la borne d'entrée du signal et d'une borne VC.

17. Procédé suivant la revendication 15 ou 16, dans lequel, au stade (e), on ajuste la fréquence pour une pluralité d'oscillateurs commandés en tension restant connectés à la grille (1) de connexion.
